(19)

Europäisches Patentamt

European Patent Office

Office européen des brevets

(11) **EP 4 258 495 A1**

(12) **EUROPEAN PATENT APPLICATION**
published in accordance with Art. 153(4) EPC

(43) Date of publication:
**11.10.2023 Bulletin 2023/41**

(21) Application number: **21900402.5**

(22) Date of filing: **15.11.2021**

(51) International Patent Classification (IPC):
**H01S 5/125** (2006.01)    **G01S 17/34** (2020.01)
**G02F 1/015** (2006.01)    **G02F 1/025** (2006.01)
**G02F 2/00** (2006.01)

(52) Cooperative Patent Classification (CPC):
**G02F 1/025; G01S 17/34; G02F 1/015; G02F 2/00;
G02F 2/008; H01S 5/125**

(86) International application number:
**PCT/JP2021/041937**

(87) International publication number:
**WO 2022/118647 (09.06.2022 Gazette 2022/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.12.2020   JP 2020202218**

(71) Applicants:
• **Panasonic Holdings Corporation
  Osaka 571-8501 (JP)**
• **Universiteit Gent
  9000 Gent (BE)**
• **Imec VZW
  3001 Leuven (BE)**

(72) Inventors:
• **NAKAMURA, Tasuku
  Osaka-shi, Osaka 540-6207 (JP)**
• **INADA, Yasuhisa
  Osaka-shi, Osaka 540-6207 (JP)**
• **KJELLMAN, Jon
  3001 Leuven (BE)**
• **KUYKEN, Bart
  9052 Gent (BE)**
• **GASSE, Kasper Van
  9052 Gent (BE)**
• **HERMANS, Artur
  9052 Gent (BE)**

(74) Representative: **Novagraaf International SA
Chemin de l'Echo 3
1213 Onex, Geneva (CH)**

(54) **OPTICAL FREQUENCY COMB DEVICE AND MEASUREMENT DEVICE**

(57) An optical frequency comb device (10A) includes: an optical waveguide (13w); a mirror (13m1) disposed at a first position in the optical waveguide (13w); a mirror (13m2) disposed at a second position different from the first position, in the optical waveguide (13w); a gain medium (13g) and a saturable absorber (13sa) which are disposed between the mirror (13m1) and the mirror (13m2); and a controller that fixes one of a repetition frequency and a carrier-envelope offset frequency of an optical frequency comb output from an end of the optical waveguide (13w), and changes the other of the repetition frequency and the carrier-envelope offset frequency.

FIG. 6

EP 4 258 495 A1

**Description**

[Technical Field]

The present disclosure relates to an optical frequency comb device and a measurement device.

[Background Art]

Characteristics of a target on its optical frequency can be examined by irradiating the target with light to obtain a frequency spectrum of light passing through the target or reflected by the target. To obtain such a frequency spectrum of light, of which the frequency is high, a light source with varying intensity and a diffraction grating, a prism, or the like have been used to split the light. This limits the accuracy of the obtained frequency spectrum.

However, the optical frequency comb technology is making it possible to obtain accurate frequency spectra of light. An optical frequency comb refers to a comb-like frequency spectrum consisting of a plurality of discrete, equally spaced longitudinal modes. In this specification, laser light with an optical frequency comb is referred to as "optical frequency comb laser light" or simply "optical frequency comb". Non Patent Literature (NPL) 1 to 3 disclose optical frequency comb devices that generate optical frequency combs.

[Citation List]

[Non Patent Literature]

[NPL 1] A. L. Gaeta et al., "Photonic-chip-based frequency combs", Nature Photonics, 2019, Vol. 13, pp. 158-169
[NPL 2] J. Riemensberger et al., "Massively parallel coherent laser ranging using a soliton microcomb", Nature, 2020, Vol. 581, pp. 161-170
[NPL 3] Z. Wang et al., "A III-V-on-Si ultra-dense comb laser", Light: Science & Applications, 2017, Vol. 6, e16260

[Summary of Invention]

[Technical Problem]

In order to apply optical frequency combs to various uses, it is required that the frequencies be accurately changed.

The present disclosure provides an optical frequency comb device and the like that can accurately change the frequency.

[Solution to Problem]

An optical frequency comb device according to an aspect of the present disclosure includes: an optical waveguide; a first mirror disposed at a first position in the optical waveguide; a second mirror disposed at a second position different from the first position, in the optical waveguide; a gain medium and a saturable absorber which are disposed between the first mirror and the second mirror; and a controller that fixes one of a repetition frequency and a carrier-envelope offset frequency of an optical frequency comb output from an end of the optical waveguide, and changes the other of the repetition frequency and the carrier-envelope offset frequency.

Furthermore, an optical frequency comb device according to another aspect of the present disclosure includes: an optical waveguide; a first mirror disposed at a first position in the optical waveguide; a second mirror disposed at a second position different from the first position, in the optical waveguide; a gain medium and a saturable absorber which are disposed between the first mirror and the second mirror; and a signal generator that supplies a radio frequency signal to the saturable absorber, wherein the signal generator changes a repetition frequency of an optical frequency comb output from an end of the optical waveguide, by changing a frequency of the radio frequency signal.

A measurement device according to an aspect of the present disclosure includes: the optical frequency comb device according to the aspect described above; an emitter that emits the optical frequency comb toward a target; a light detector into which reflected light of the optical frequency comb that is reflected by the target enters; and an arithmetic unit that calculates a distance to the target or a speed of the target, based on a result of detection by the light detector.

[Advantageous Effects of Invention]

An optical frequency comb device and the like according to an aspect of the present disclosure enable accurate frequency changes.

[Brief Description of Drawings]

[FIG. 1A]

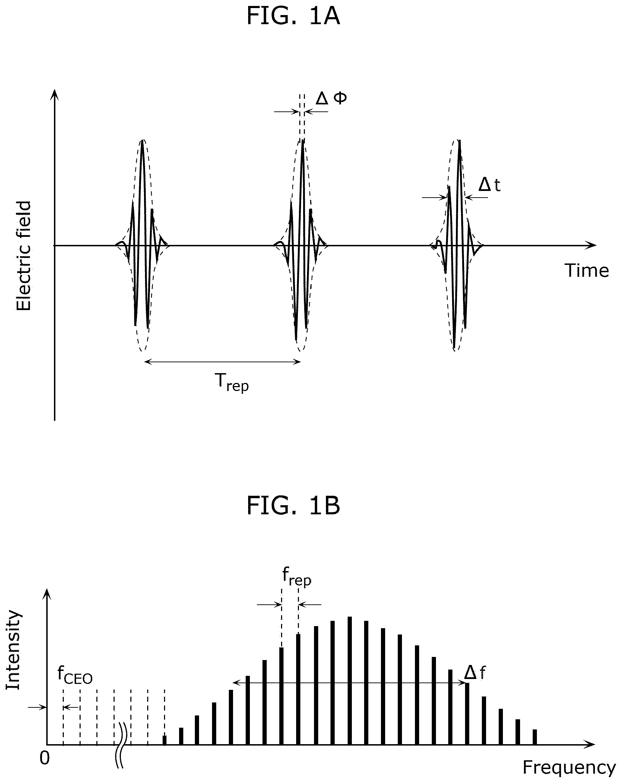

FIG. 1A schematically illustrates changes over time in the electric field of an optical frequency comb laser light.
[FIG. 1B]
FIG. 1B schematically illustrates the frequency spectrum of the optical frequency comb laser light.
[FIG. 2A]

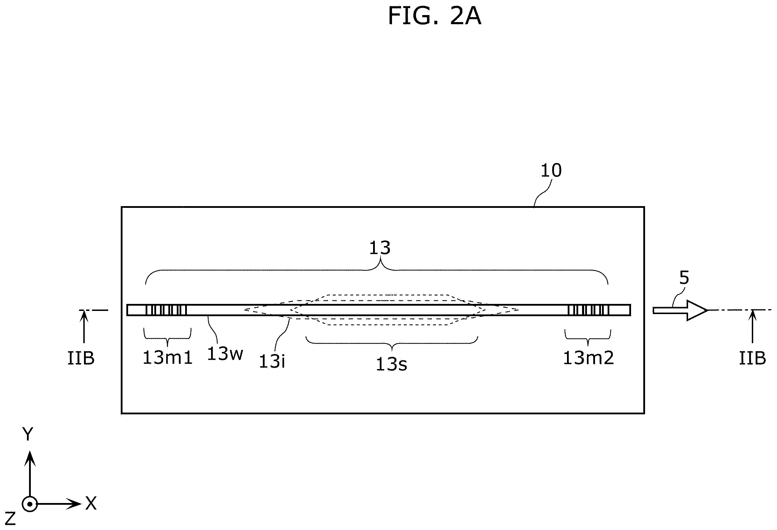

FIG. 2A is a schematic top view of an optical frequency comb laser source that includes a resonator including gain media integrated on a semiconductor substrate.
[FIG. 2B]

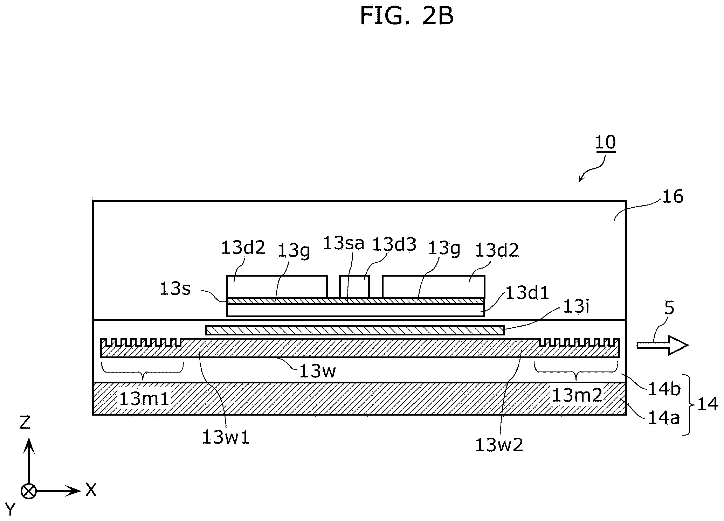

FIG. 2B is a schematic cross-sectional view of the optical frequency comb laser source taken along line IIB-IIB in FIG. 2A.
[FIG. 2C]

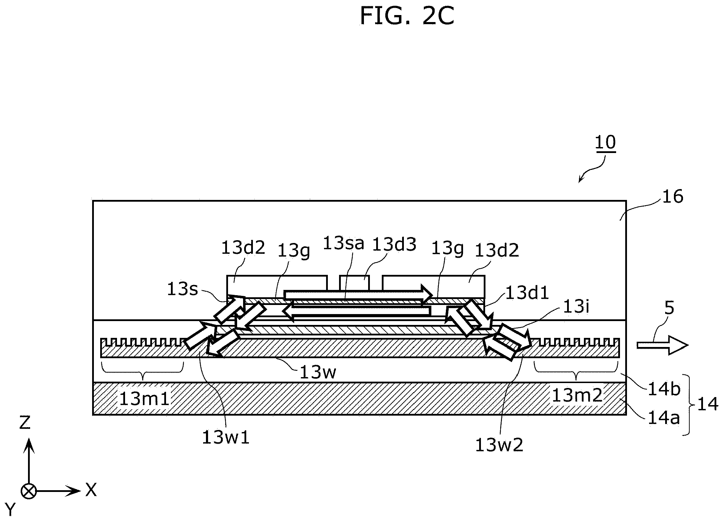

FIG. 2C is a schematic cross-sectional view of propagating paths of light in the cross-section illustrated in FIG. 2B.
[FIG. 3]

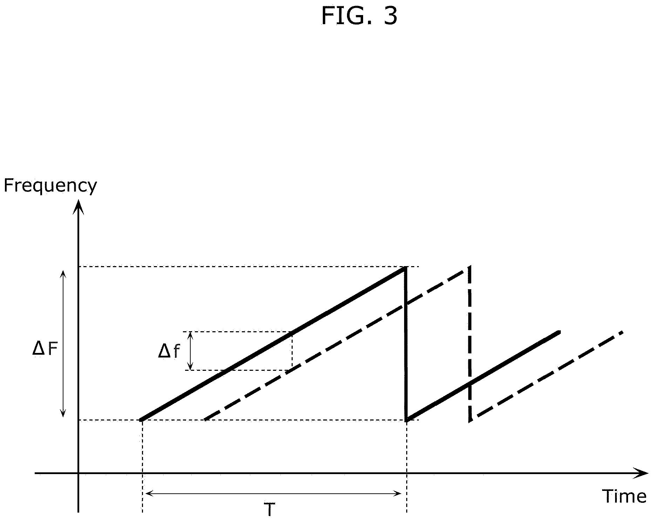

FIG. 3 illustrates the principle of distance measurement in FMCW.
[FIG. 4]

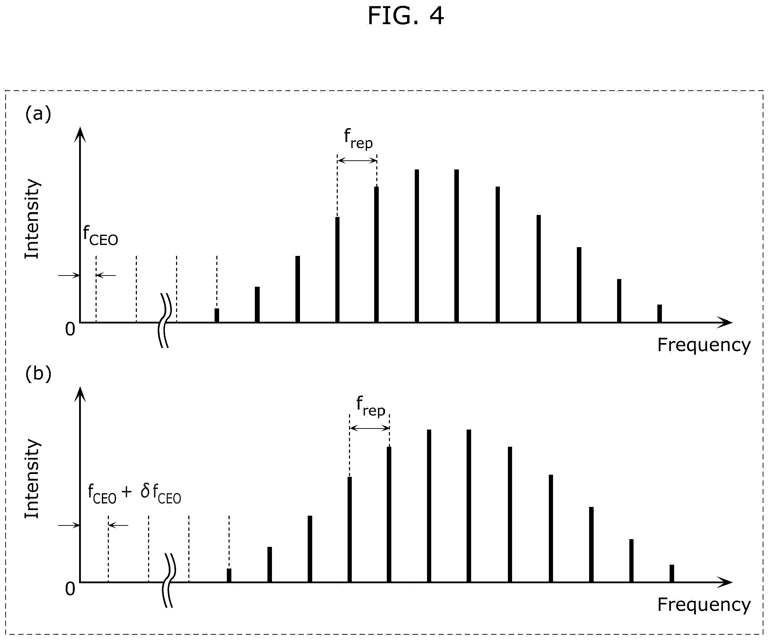

FIG. 4 illustrates an optical frequency comb on a frequency axis before and after a carrier-envelope offset frequency is modulated.
[FIG. 5]

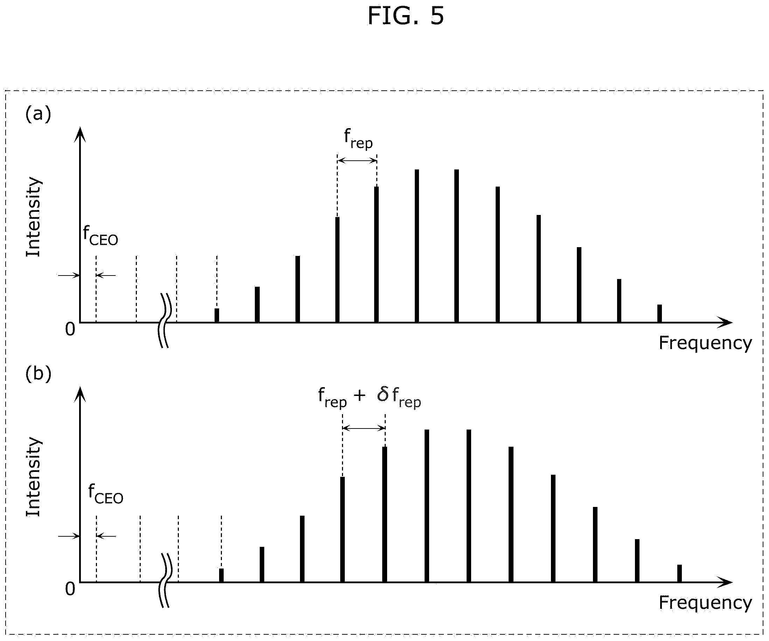

FIG. 5 illustrates the optical frequency comb on a frequency axis before and after a repetition frequency is modulated.
[FIG. 6]

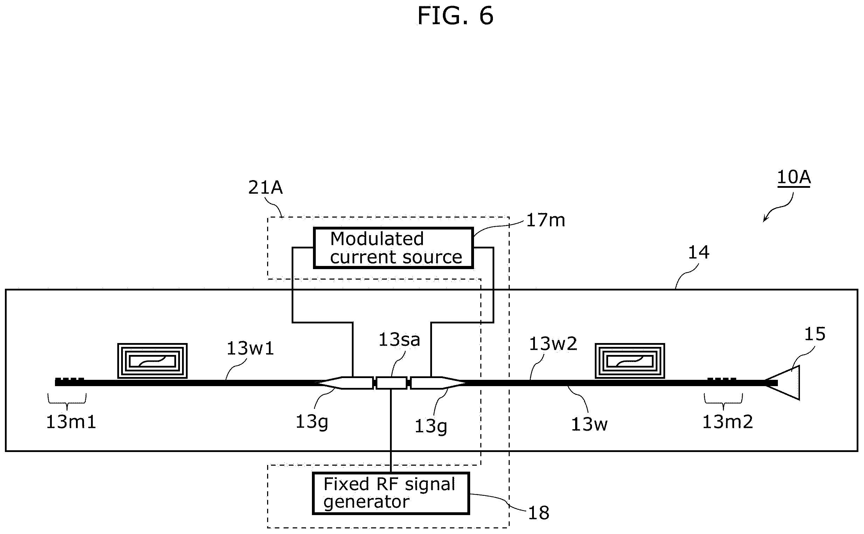

FIG. 6 schematically illustrates an example of an optical frequency comb device according to Embodiment 1.
[FIG. 7]

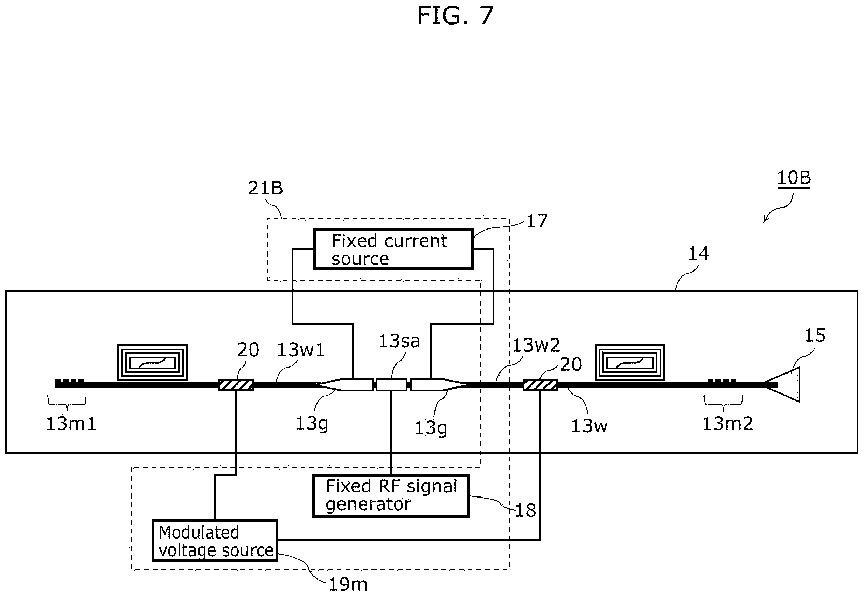

FIG. 7 schematically illustrates an example of an optical frequency comb device according to Embodiment 2.
[FIG. 8]

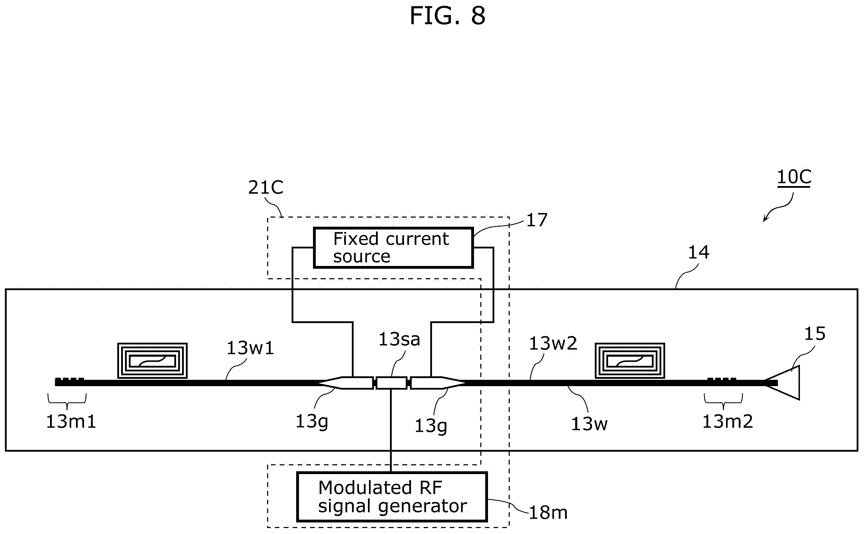

FIG. 8 schematically illustrates an example of an optical frequency comb device according to Embodiment 3.
[FIG. 9]

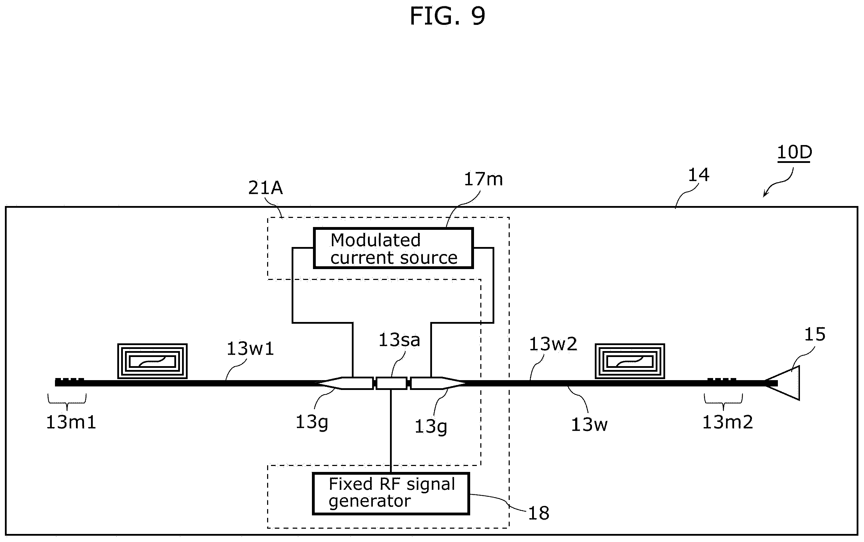

FIG. 9 schematically illustrates an example of an optical frequency comb device according to a variation of the embodiments.
[FIG. 10]

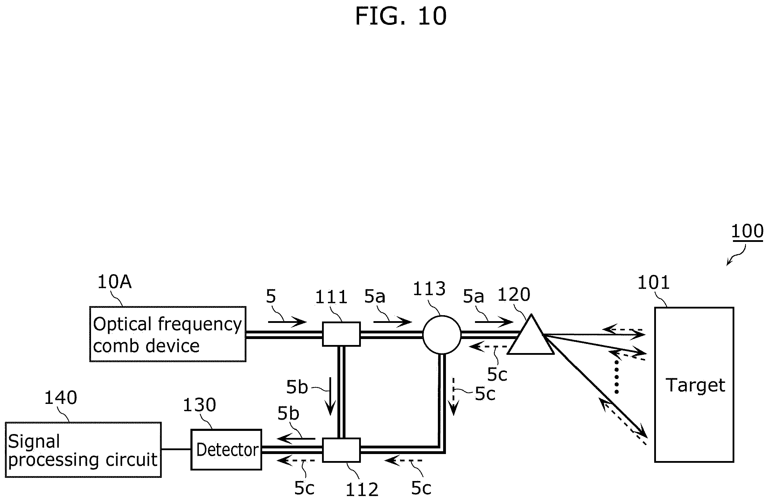

FIG. 10 schematically illustrates a configuration of a measurement device according to Embodiment 4.
[FIG. 11]

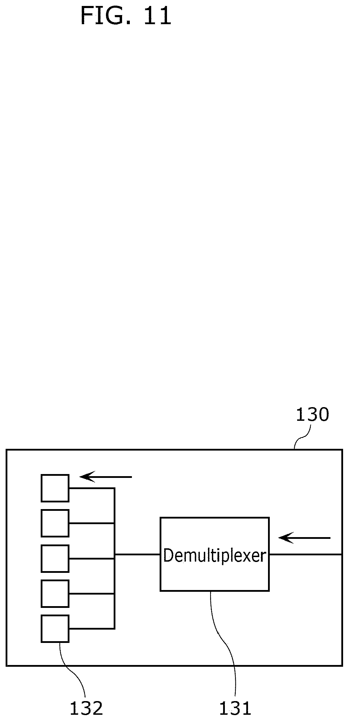

FIG. 11 schematically illustrates a configuration of a detector in the measurement device according to Embodiment 4.

[Description of Embodiments]

(Overview of present disclosure)

An optical frequency comb device according to an aspect of the present disclosure includes: an optical waveguide; a first mirror disposed at a first position in the optical waveguide; a second mirror disposed at a second position different from the first position, in the optical waveguide; a gain medium and a saturable absorber which are disposed between the first mirror and the second mirror; and a controller that fixes one of a repetition frequency and a carrier-envelope offset frequency of an optical frequency comb output from an end of the optical waveguide, and changes the other of the repetition frequency and the carrier-envelope offset frequency.

Thus, both the repetition frequency and the carrier-envelope offset frequency do not change simultaneously, enabling the frequency of the optical frequency comb to be accurately changed to a desired frequency. Frequency modulation can be an example of changing the frequency.

Furthermore, for example, the controller may include: a current source that supplies current to the gain medium; and a signal generator that supplies a radio frequency signal to the saturable absorber.

This enables the carrier-envelope offset frequency to be fixed or changed according to the magnitude of the current supplied to the gain medium. This also enables the repetition frequency to be fixed or changed according to the frequency of the radio frequency signal supplied to the saturable absorber.

Furthermore, for example, the current source may change the carrier-envelope offset frequency by changing a magnitude of the current, and the signal generator may fix a frequency of the radio frequency signal.

Thus, a plurality of modes (that is, frequency components) of the optical frequency comb can be easily changed by changing the carrier-envelope offset frequency. Moreover, the repetition frequency can be fixed, and thus the modes can be easily separated by a detector. This enables distance measurement based on FMCW (Frequency-modulated Continuous-wave) to be easily performed.

Furthermore, for example, the current source may fix a magnitude of the current, and the signal generator may change the repetition frequency by changing a frequency of the radio frequency signal.

This enables FMCW-based distance measurement even when the repetition frequency is changed.

Furthermore, for example, the optical frequency comb device according to an aspect of the present disclosure may further include a phase modulator disposed between the first mirror and the second mirror. The controller may further include a voltage source that supplies a voltage to the phase modulator. The voltage source may change the carrier-envelope offset frequency by changing a magnitude of the voltage, and the signal generator may fix a frequency of the radio frequency signal.

Thus, a plurality of modes (that is, frequency components) of the optical frequency comb can be easily changed by changing the carrier-envelope offset frequency. Moreover, the repetition frequency can be fixed, and thus the modes can be easily separated by a detector. This enables FMCW-based distance measurement to be easily performed.

Furthermore, for example, the optical frequency comb device according to an aspect of the present disclosure may further include a semiconductor substrate. The optical waveguide, the first mirror, the second mirror, the gain medium, and the saturable absorber may be integrated on the semiconductor substrate.

This can reduce the size of the optical frequency comb device. Moreover, the frequency can be easily changed compared with a case where a CW laser light source and a microresonator that generates optical frequency combs by resonating laser light emitted from the CW laser light source are provided. That is, theoretically, an optical frequency comb of which the repetition frequency or the carrier-envelope offset frequency is changed can be obtained by changing the frequency of laser light from the CW laser light source. However, it is difficult to keep causing resonance between the CW laser light source and the microresonator while changing the frequency of the laser light from the CW laser light source, inhibiting the accuracy of frequency change from being maintained. In contrast, an on-chip optical frequency comb device that includes a gain medium, as does the optical frequency comb device according to an aspect of the present disclosure, can accurately change the frequency of the optical frequency comb to a desired frequency using the controller.

Furthermore, for example, the controller may be integrated on the semiconductor substrate.

This can further reduce the size of the optical frequency comb device.

Furthermore, an optical frequency comb device according to another aspect of the present disclosure includes: an optical waveguide; a first mirror disposed at a first position in the optical waveguide; a second mirror disposed at a second position different from the first position, in the optical waveguide; a gain medium and a saturable absorber which are disposed between the first mirror and the second mirror; and a signal generator that supplies a radio frequency signal to the saturable absorber. Here, the signal generator changes a repetition frequency of an optical frequency comb output from an end of the optical waveguide, by changing a frequency of the radio frequency signal.

Thus, the repetition frequency can be accurately changed according to changes in the frequency of the radio frequency signal.

The optical frequency comb device according to the other aspect of the present disclosure may further include a current source that supplies current to the gain medium. The current source may fix a magnitude of the current.

Thus, both the repetition frequency and the carrier-envelope offset frequency do not change simultaneously, enabling the frequency of the optical frequency comb to be accurately changed to a desired frequency.

Furthermore, a measurement device according to an aspect of the present disclosure includes: the optical frequency comb device according to either one of the aspects described above; an emitter that emits the optical frequency comb toward a target; a light detector into which reflected light of the optical frequency comb that is reflected by the target enters; and an arithmetic unit that calculates a distance to the target or a speed of the target, based on a result of detection by the light detector.

Thus, one of the carrier-envelope offset frequency and the repetition frequency can be fixed while the other is changed, enabling FMCW-based distance measurement to be easily performed.

Furthermore, for example, the optical frequency comb may further enter the light detector, and the arithmetic unit may calculate the distance or the speed based on a beat signal generated by interference between the reflected light and the optical frequency comb in the light detector.

Thus, in addition to the distance, the speed can also be easily calculated using the beat signal.

Furthermore, for example, the light detector may include: a demultiplexer that separates light entering the light detector into light beams per frequency; and light receptors that receive the light beams separated per frequency.

This enables detection using, for example, WDM (Wavelength Division Multiplexing). A plurality of modes can be detected separately, allowing the modulation range of each mode to be increased.

Furthermore, for example, the emitter may emit the optical frequency comb in a different direction per frequency.

This enables the distances to and/or speeds of multiple points to be measured simultaneously.

Hereinafter, embodiments will be described in detail with reference to the drawings.

Note that each of the embodiments described below shows a generic or specific example. The numerical values, shapes, materials, components, the arrangement and connection of the components, steps, the processing order of the steps, etc., shown in the following embodiments are mere examples, and thus are not intended to limit the present disclosure. Furthermore, among the components described in the following embodiments, components not recited in any one of the independent claims are described as optional components.

Furthermore, the respective figures are schematic diagrams and are not necessarily precise illustrations. Therefore, for example, the scaling, and so on, depicted in the drawings is not necessarily uniform. Furthermore, in the figures, elements which are substantially the same are given the same reference signs, and overlapping description is omitted or simplified.

Additionally, in the present description, terms indicating relations between components, such as "parallel" or "coincide"; terms indicating shapes of components, such as "rectangle"; and numerical ranges are not strictly defined and include a substantially same range or a margin of error of a few percent.

Furthermore, in the present description, the terms "above" and "below" are not in the absolute upward and downward directions (vertically upward and downward directions, respectively) in spatial perception but are used as terms defined by the relative positions of layers in the multilayer structure, which are based on the order of stacking of the layers. Moreover, the terms "above" and "below" are used to describe not only a situation in which two components are spaced with another component present therebetween, but also a situation in which two components touch, such as when two components are placed so as to be in direct contact with each other.

In this specification, unless otherwise specified, the use of ordinal numbers, such as "first" and "second", is to avoid confusion among components of the same kind and to distinguish respective components rather than to denote the number or the order of those components.

(Optical frequency comb)

First, changes over time in the electric field and the frequency spectrum of an optical frequency comb (that is, an optical frequency comb laser light) will be described with reference to FIGS. 1A and 1B.

FIG. 1A schematically illustrates an example of changes over time in the electric field of the optical frequency comb laser light. In FIG. 1A, the horizontal axis represents time, whereas the vertical axis represents the electric field of the laser light.

As illustrated in FIG. 1A, the optical frequency comb laser light consists of an optical pulse train generated with cycle period $T_{rep}$. Cycle period $T_{rep}$ ranges from, for example, 100 ps to 100 ns. The full width at half maximum (FWHM) of each optical pulse is denoted by $\Delta t$. FWHM $\Delta t$ of each optical pulse ranges from, for example, 10 fs to 1 ps.

The source of the optical frequency comb laser light includes a laser resonator that emits optical frequency comb laser light in response to input of excitation light or charge injection. The details of the laser resonator will be described later. In the laser resonator, group velocity $v_g$, with which the envelopes of optical pulses propagate, may differ from phase velocity $v_p$, with which waves in the optical pulses propagate. The difference between group velocity $v_g$ and phase velocity $v_p$ causes the phases of the waves in the optical pulses to be shifted by $\Delta\varphi$ when two adjacent optical pulses are superposed such that the envelopes coincide. $\Delta\varphi$ is less than 2n. The cycle period of the optical pulse train is expressed as $T_{rep} = L/v_g$, where L is the round-trip length of the laser resonator.

FIG. 1B schematically illustrates the frequency spectrum of the optical frequency comb laser light. In FIG. 1B, the horizontal axis represents frequency, whereas the vertical axis represents the intensity of the laser light.

As illustrated in FIG. 1B, the optical frequency comb laser light has a comb-like frequency spectrum consisting of a plurality of discrete, equally spaced frequency lines. The frequencies of the plurality of discrete, equally spaced frequency lines correspond to resonant frequencies of longitudinal modes in the laser resonator. The repetition frequency, which corresponds to the spacing between two adjacent equally spaced frequency lines in the optical frequency comb, is expressed as $f_{rep} = 1/T_{rep}$. Repetition frequency $f_{rep}$ ranges from, for example, 10 MHz to 10 GHz. If optical length L of the laser resonator is 30 cm and group velocity $v_g$ is substantially equal to the velocity of light in the vacuum (= $3 \times 10^8$ m/s), cycle period $T_{rep}$ becomes 1 ns, and repetition frequency $f_{rep}$ becomes 1 GHz.

If the FWHM of the optical frequency comb is denoted as $\Delta f$, then $\Delta f = 1/\Delta t$. FWHM $\Delta f$ of the optical frequency comb ranges from, for example, 1 THz to 100 THz. Assuming that the equally spaced frequency lines lie adjacent to the zero frequency, the frequency of the equally spaced frequency line closest to the zero frequency is referred to as "carrier-envelope offset frequency". The carrier-envelope offset frequency is expressed as $f_{CEO} = (\Delta\varphi/(2\pi))f_{rep}$. Carrier-envelope

offset frequency $f_{CEO}$ is less than repetition frequency $f_{rep}$. Assuming that carrier-envelope offset frequency $f_{CEO}$ is the zeroth mode frequency, nth mode frequency $f_n$ in the optical frequency comb is expressed as $f_n = f_{CEO} + nf_{rep}$. Electric field $E(t)$ of the optical frequency comb laser light illustrated in FIG. 1A is expressed as $E(t) = \Sigma nE_n \exp[-i(2\pi f_n t + \varphi_n)]$, where $E_n$ and $\varphi_n$ are the amplitude and phase, respectively, of the electric field at nth mode frequency $f_n$.

(Optical frequency comb device)

Next, an optical frequency comb device of a type integrated on a semiconductor substrate, or an on-chip optical frequency comb device, will be described briefly with reference to FIGS. 2A and 2B. The optical frequency comb device is also referred to as "optical frequency comb laser source".

FIG. 2A is a schematic top view of an optical frequency comb laser source that includes a resonator including gain media integrated on a semiconductor substrate. FIG. 2B is a schematic cross-sectional view of the optical frequency comb laser source taken along line IIB-IIB in FIG. 2A. An X-axis, a Y-axis, and a Z-axis orthogonal to each other are schematically illustrated for purposes of explanation and are not intended to limit the directions during use. Moreover, hatch patterns, which represent cross-sections, are not provided for n-doped layer 13d1, p-doped layers 13d2 and 13d3, low refractive index layer 14b, and protective layer 16 in FIG. 2B.

As illustrated in FIGS. 2A and 2B, optical frequency comb laser source 10 includes resonator 13, semiconductor substrate 14, and protective layer 16. The surfaces of semiconductor substrate 14 in the illustrated example are parallel to an XY plane. As illustrated in FIG. 2B, semiconductor substrate 14 has a layered structure including high refractive index layer 14a made of, for example, Si and low refractive index layer 14b made of, for example, $SiO_2$ laminated in this order in a Z-axis direction. The refractive index of high refractive index layer 14a is higher than the refractive index of low refractive index layer 14b. Semiconductor substrate 14 may not include high refractive index layer 14a. Protective layer 16 is formed using, for example, an inorganic material such as $SiO_2$ or an organic insulating material such as BCB (benzocyclobutene). Protective layer 16 is disposed to cover the upper surface of low refractive index layer 14b.

Resonator 13 is an example of a laser resonator that has a predetermined optical length. As illustrated in FIG. 2A, resonator 13 includes semiconductor layer 13s, intermediate layer 13i, optical waveguide 13w, and mirrors 13m1 and 13m2. Moreover, as illustrated in FIG. 2B, resonator 13 includes n-doped layer 13d1 and p-doped layers 13d2 and 13d3. Resonator 13 further includes gain media 13g and saturable absorber 13sa. Parts of semiconductor layer 13s function as gain media 13g and saturable absorber 13sa.

In FIG. 2A, dotted lines indicate the shape of semiconductor layer 13s in resonator 13 in plan view. Both ends of semiconductor layer 13s are tapered. When viewed from above, the tips of the tapers overlap intermediate layer 13i. Both ends of intermediate layer 13i are also tapered. When viewed from above, the tips of the tapers overlap optical waveguide 13w. Thus, light passing through semiconductor layer 13s efficiently propagates to optical waveguide 13w via intermediate layer 13i. That is, in optical frequency comb laser source 10, optical waveguide 13w, intermediate layer 13i, and semiconductor layer 13s function as paths through which light can pass.

As illustrated in FIG. 2B, optical waveguide 13w in resonator 13 is embedded in low refractive index layer 14b of semiconductor substrate 14. Optical waveguide 13w may be disposed on or above low refractive index layer 14b. Optical waveguide 13w can be made of, for example, at least one high refractive index material selected from a group consisting of SiN and Si. The refractive index of optical waveguide 13w is higher than the refractive index of low refractive index layer 14b of semiconductor substrate 14 and the refractive index of protective layer 16. This allows light to propagate through optical waveguide 13w by total reflection.

Intermediate layer 13i is disposed between optical waveguide 13w and semiconductor layer 13s. Intermediate layer 13i is made of, for example, a-Si (amorphous silicon). The refractive index of intermediate layer 13i is higher than the refractive index of optical waveguide 13w and lower than the refractive index of semiconductor layer 13s. Intermediate layer 13i may be made of any other semiconductors with a refractive index higher than that of optical waveguide 13w and lower than that of semiconductor layer 13s. If intermediate layer 13i is not provided, the absence prevents light from propagating easily from semiconductor layer 13s, of which the refractive index is high, to optical waveguide 13w, of which the refractive index is low, because there is a significant difference in refractive index between semiconductor layer 13s and optical waveguide 13w. This results in a large loss while light propagates between semiconductor layer 13s and optical waveguide 13w. The presence of intermediate layer 13i can reduce the difference in refractive index between the layers. Thus, the presence of intermediate layer 13i allows light to propagate from semiconductor layer 13s to optical waveguide 13w as illustrated in FIG. 2C with low loss. Note that FIG. 2C is a schematic cross-sectional view of propagating paths of light in the cross-section illustrated in FIG. 2B. Intermediate layer 13i may be omitted in a case where the difference in refractive index between semiconductor layer 13s and optical waveguide 13w is small.

As illustrated in FIG. 2C, in optical waveguide 13w, first portion 13w1 adjacent to mirror 13m1 and second portion 13w2 adjacent to mirror 13m2 function as the propagating paths of light. In optical waveguide 13w, first portion 13w1 lies between mirror 13m1 and gain medium 13g and saturable absorber 13sa. In optical waveguide 13w, second portion 13w2 lies between mirror 13m2 and gain medium 13g and saturable absorber 13sa.

Mirror 13m1 is disposed at a first position in optical waveguide 13w. Specifically, mirror 13m1 is disposed at an end of optical waveguide 13w. Mirror 13m1 can be formed of, for example, a distributed Bragg reflector. In the distributed Bragg reflector, light is reflected by Bragg reflection resulting from a periodic refractive index structure. Mirror 13m1 reflects light propagating through optical waveguide 13w. Mirror 13m1 may be made of, for example, any reflective metals. Moreover, mirror 13m1 may be a reflective element, such as a loop mirror, made of semiconductor. The same applies to mirror 13m2. Mirror 13m2 is disposed at a second position different from the first position, in optical waveguide 13w. Specifically, mirror 13m2 is disposed at the other end of optical waveguide 13w opposite mirror 13m1.

Mirror 13m2 has a lower reflectivity than mirror 13m1. Specifically, the reflectivity of mirror 13m1 is substantially equal to 100%, whereas the reflectivity of mirror 13m2 ranges from, for example, 70% to 90%. Mirror 13m2 allows part of light propagating through optical waveguide 13w to pass therethrough, while reflecting most of the light. The light passing through mirror 13m2 becomes optical frequency comb laser light 5.

As illustrated in FIG. 2B, semiconductor layer 13s is held between n-doped layer 13d1 and p-doped layers 13d2 and 13d3. The arrangement of n-doped layer 13d1 and p-doped layers 13d2 and 13d3 may be reversed.

Semiconductor layer 13s, n-doped layer 13d1, and p-doped layers 13d2 and 13d3 are embedded in protective layer 16. The lower surface of n-doped layer 13d1 may be in contact with a surface of semiconductor substrate 14. N-doped layer 13d1 may be in contact with intermediate layer 13i.

Semiconductor layer 13s can be made of, for example, III-V semiconductor materials. The III-V semiconductor materials can include at least one material selected from a group consisting of, for example, ZnSe, InGaAlP, InGaAs, GaInAsP, GaInAsSb, InP, GaN, GaAs, AlGaAs, and AlInGaN.

Semiconductor layer 13s includes gain media 13g and saturable absorber 13sa. Gain media 13g and saturable absorber 13sa are disposed between mirrors 13m1 and 13m2. Specifically, gain media 13g and saturable absorber 13sa are disposed on the propagating paths of light between mirrors 13m1 and 13m2.

Gain media 13g are parts of semiconductor layer 13s and are held between n-doped layer 13d1 and p-doped layers 13d2. Saturable absorber 13sa is a part of semiconductor layer 13s and is held between n-doped layer 13d1 and p-doped layer 13d3.

N-doped layer 13d1 is an n-type semiconductor layer. N-doped layer 13d1 is formed by doping the III-V semiconductor materials that are identical to those of semiconductor layer 13s with n-type impurities. For example, tetravalent elements, such as Si, or hexavalent elements, such as selenium (Se), may be used as the n-type impurities.

P-doped layers 13d2 and 13d3 are p-type semiconductor layers. P-doped layers 13d2 and 13d3 are formed by doping the III-V semiconductor materials that are identical to those of semiconductor layer 13s with p-type impurities. For example, bivalent elements, such as zinc (Zn), may be used as the p-type impurities. P-doped layers 13d2 and p-doped layer 13d3 have, for example, an identical composition.

P-doped layers 13d2 and p-doped layer 13d3 are separated from each other. Electrodes (not illustrated) that are different from each other are attached to respective p-doped layers 13d2 and 13d3. Currents are applied to p-doped layers 13d2 through the electrodes. A reverse bias voltage is applied to p-doped layer 13d3 with respect to n-doped layer 13d1. The voltage application causes a part, in contact with p-doped layer 13d3, of semiconductor layer 13s to function as saturable absorber 13sa. Saturable absorber 13sa may be formed using a carbon nanotube. Moreover, saturable absorber 13sa may be integral to mirrors 13m1 and 13m2.

An electrode (not illustrated) is attached to n-doped layer 13d1 similarly to p-doped layers 13d2. The parts of semiconductor layer 13s to which electrical charges are applied through the electrodes attached to n-doped layer 13d1 and p-doped layers 13d2 function as gain media 13g from which light is radiated by stimulated emission. The light radiated by stimulated emission is repeatedly reflected between mirrors 13m1 and 13m2 through intermediate layer 13i and optical waveguide 13w. That is, the light radiated by stimulated emission is amplified by passing through gain media 13g many times. The amplified light becomes an optical pulse train mode-locked with saturable absorber 13sa. Only wavelengths corresponding to the products of the optical length, that is, the cavity length of resonator 13 and the refractive indices are amplified. This causes optical frequency comb laser light 5 to be emitted from resonator 13. Note that the optical length of resonator 13 corresponds to the optical length between mirrors 13m1 and 13m2.

(FMCW)

The optical frequency comb device according to the embodiments can be used for an FMCW. The principle of the FMCW will now be described with reference to FIG. 3. FIG. 3 illustrates the principle of distance measurement in the FMCW. In FIG. 3, the horizontal axis represents time, whereas the vertical axis represents the frequency of laser light.

In the FMCW, the frequency of laser light emitted from a CW light source is modulated over time. In the case illustrated in FIG. 3, the frequency is modulated by ΔF during time period T. The frequency modulation herein is a linear modulation. That is, the rate of change of frequency is constant.

For use in measurement of distance to a target, the frequency modulated laser light is split into two light beams. The target is then irradiated with one of the light beams serving as reference light (indicated by a solid line in FIG. 3) and with the other serving as measurement light. Reflected light (indicated by a long dashed line in FIG. 3) reflected by the target is detected by a light receptor. At this moment, there is a frequency difference of $\Delta f$ between the reference light and the measurement light (that is, the reflected light). This results from a time difference that occurs while the measurement light goes to and comes back from the target. Thus, the distance to the target can be measured by multiplying the frequency difference $\Delta f$ by $cT/2\Delta F$. That is, the distance can be expressed by the following expression (1).

$$(1)\ \text{Distance} = \Delta f \times c \times T/(2 \times \Delta F),$$

Here, c denotes the velocity of light. For example, if $T = 40\ \mu s$, $\Delta F = 4$ GHz, and $\Delta f = 4$ MHz, the distance to the target can be calculated as 6 m, using expression (1).

(Two frequency modulation methods in optical frequency comb)

In a measurement device according to the present disclosure, the FMCW-based distance measuring method is applied to the optical frequency comb device.

As has been already mentioned, the optical frequency comb has two frequency parameters of repetition frequency $f_{rep}$ and carrier-envelope offset frequency $f_{CEO}$. Thus, modulation of one of the frequencies enables distance measurement as in the FMCW.

First, a case where only carrier-envelope offset frequency $f_{CEO}$ is modulated will be described with reference to FIG. 4. FIG. 4 illustrates the optical frequency comb on a frequency axis before and after carrier-envelope offset frequency $f_{CEO}$ is modulated. Specifically, in FIG. 4, (a) illustrates the optical frequency comb before modulation, whereas (b) illustrates the optical frequency comb after modulation. In each of (a) and (b), the horizontal axis represents the frequency of light, whereas the vertical axis represents the intensity of light.

When the value of the carrier-envelope offset frequency before modulation is $f_{CEO}$, the carrier-envelope offset frequency takes a value of $f_{CEO} + \delta f_{CEO}$ at a point in time. Thus, nth mode frequency $f_n$ can be expressed as $f_n = (f_{CEO} + \delta f_{CEO}) + n f_{rep}$. By regarding each mode (specifically, light beam with each frequency component) as laser light from a CW light source, FMCW can be performed multiple times simultaneously.

Next, a case where only repetition frequency $f_{rep}$ is modulated will be described with reference to FIG. 5. FIG. 5 illustrates the optical frequency comb on a frequency axis before and after repetition frequency $f_{rep}$ is modulated. In FIG. 5, (a) illustrates the optical frequency comb before modulation, whereas (b) illustrates the optical frequency comb after modulation. In each of (a) and (b), the horizontal axis represents the frequency of light, whereas the vertical axis represents the intensity of light.

When the value of the repetition frequency before modulation is $f_{rep}$, the repetition frequency takes a value of $f_{rep} + \delta f_{rep}$ at a point in time. Thus, nth mode frequency $f_n$ can be expressed as $f_n = f_{CEO} + n(f_{rep} + \delta f_{rep})$. As in the case illustrated in FIG. 4, FMCW can be performed multiple times simultaneously by regarding each mode as laser light from the CW light source.

Note that frequency modulation methods include EOM (electro-optic modulation) and modulation of cavity lengths by adjusting temperature. However, in the on-chip optical frequency comb device including the gain media, modulation of the amount of current applied to the gain media or modulation of the cavity length by adjusting temperature causes both repetition frequency $f_{rep}$ and carrier-envelope offset frequency $f_{CEO}$ to change. This inhibits the optical frequency comb device from functioning as an FMCW.

To solve this, in the present disclosure, the optical frequency comb device includes a modulator that modulates one of repetition frequency $f_{rep}$ and carrier-envelope offset frequency $f_{CEO}$ while fixing the other. Specific configurations of optical frequency comb devices according to the embodiments of the present disclosure will be described below.

[Embodiment 1]

First, a configuration example of an optical frequency comb device according to Embodiment 1 of the present disclosure will be described with reference to FIG. 6. FIG. 6 schematically illustrates optical frequency comb device 10A according to the present embodiment. The basic configuration of optical frequency comb device 10A is identical to that of optical frequency comb laser source 10 illustrated in FIGS. 2A and 2B. The following primarily describes differences from optical frequency comb laser source 10 illustrated in FIGS. 2A and 2B, and descriptions of common features will be omitted or simplified.

As illustrated in FIG. 6, optical frequency comb device 10A differs in further including modulator 21A. Modulator 21A is an example of a controller and includes modulated current source 17m and fixed RF signal generator 18.

Modulated current source 17m is connected to gain media 13g to supply gain media 13g with current of which the magnitude is modulated (hereinafter referred to as "modulated current"). Specifically, modulated current source 17m is connected to p-doped layers 13d2 and n-doped layer 13d1 to allow the modulated current to pass from p-doped layers 13d2 to n-doped layer 13d1. This causes the modulated current to be supplied to gain media 13g that are held between p-doped layers 13d2 and n-doped layer 13d1.

Fixed RF signal generator 18 is connected to saturable absorber 13sa to supply saturable absorber 13sa with a radio frequency signal of which the frequency is fixed (hereinafter referred to as "fixed RF signal"). Specifically, fixed RF signal generator 18 is connected to p-doped layer 13d3 and n-doped layer 13d1 to supply, between p-doped layer 13d3 and n-doped layer 13d1, a radio frequency voltage signal of which the frequency is fixed as the fixed RF signal. This causes the fixed RF signal to be supplied to saturable absorber 13sa that is held between p-doped layer 13d3 and n-doped layer 13d1.

Modulated current source 17m modulates the carrier-envelope offset frequency by modulating the magnitude of the current supplied to gain media 13g. At this moment, modulation of the magnitude of the current causes modulation of the repetition frequency in addition to the carrier-envelope offset frequency.

In contrast, fixed RF signal generator 18 fixes the repetition frequency by fixing the frequency of the radio frequency signal. This is because saturable absorber 13sa functions as a shutter due to the fixed RF signal and controls the pulse interval inside the resonator.

This, as a result, achieves optical frequency comb device 10A that modulates only the carrier-envelope offset frequency, enabling FMCW-based distance measurement. More specifically, optical frequency comb device 10A can measure the distances to many points simultaneously. Specific distance measurement will be described later.

[Embodiment 2]

Next, a configuration example of an optical frequency comb device according to Embodiment 2 of the present disclosure will be described with reference to FIG. 7. FIG. 7 schematically illustrates optical frequency comb device 10B according to the present embodiment. The basic configuration of optical frequency comb device 10B is identical to that of optical frequency comb laser source 10 illustrated in FIGS. 2A and 2B. The following primarily describes differences from optical frequency comb laser source 10 illustrated in FIGS. 2A and 2B, and descriptions of common features will be omitted or simplified.

As illustrated in FIG. 7, optical frequency comb device 10B differs in further including phase modulators 20 and modulator 21B.

Phase modulators 20 are inserted in optical waveguide 13w. Phase modulators 20 are disposed between mirrors 13m1 and 13m2. In the present embodiment, two phase modulators 20 are respectively inserted in first portion 13w1 and in second portion 13w2.

Modulator 21B is an example of the controller and includes fixed current source 17, fixed RF signal generator 18, and modulated voltage source 19m.

Fixed current source 17 is connected to gain media 13g to supply gain media 13g with current of which the magnitude is fixed (hereinafter referred to as "fixed current"). Specifically, fixed current source 17 is connected to p-doped layers 13d2 and n-doped layer 13d1 to allow the fixed current to pass from p-doped layers 13d2 to n-doped layer 13d1. This causes the fixed current to be supplied to gain media 13g that are held between p-doped layers 13d2 and n-doped layer 13d1.

Fixed RF signal generator 18 is connected to saturable absorber 13sa to supply saturable absorber 13sa with the RF signal. The specific connection of fixed RF signal generator 18 is identical to that in Embodiment 1. Modulated voltage source 19m is connected to phase modulators 20 to supply phase modulators 20 with voltage.

Fixed current source 17 fixes the carrier-envelope offset frequency by fixing the magnitude of the current supplied to gain media 13g. Moreover, fixed RF signal generator 18 fixes the repetition frequency by fixing the frequency of the RF signal. As a result, no frequency modulation occurs in this state.

In contrast, modulated voltage source 19m modulates the carrier-envelope offset frequency by modulating the magnitude of the voltage. Specifically, the supplied voltage changes the refractive indices of phase modulators 20. The presence of phase modulators 20 in optical waveguide 13w modulates the phase of the optical frequency comb. This modulates the carrier-envelope offset frequency of the optical frequency comb. At this moment, the repetition frequency could also be modulated in addition to the carrier-envelope offset frequency. However, the repetition frequency is fixed because the frequency of the RF signal is fixed.

This, as a result, achieves optical frequency comb device 10B that modulates only the carrier-envelope offset frequency, enabling simultaneous FMCW-based distance measurement.

Optical frequency comb device 10B may include a temperature adjustment mechanism, such as a heater, instead of phase modulators 20. The temperature adjustment mechanism can change the temperature of optical waveguide 13w according to the voltage. The refractive index of optical waveguide 13w changes as optical waveguide 13w expands or contracts according to the changes in temperature. That is, the temperature adjustment mechanism can change the refractive index of optical waveguide 13w as do phase modulators 20. Thus, connecting modulated voltage source 19m to the temperature adjustment mechanism and supplying voltage of which the magnitude is modulated can produce the same effect as above. The temperature adjustment mechanism can be any component that can heat optical waveguide 13w and may be disposed outside optical waveguide 13w.

In the present embodiment, the current supplied to gain media 13g is fixed, preventing the intensity of the optical frequency comb from being modulated. This enables optical frequency comb device 10B to be also available for use that requires an optical frequency comb with a constant intensity and thus to be more versatile.

[Embodiment 3]

Next, a configuration example of an optical frequency comb device according to Embodiment 3 of the present disclosure will be described with reference to FIG. 8. FIG. 8 schematically illustrates optical frequency comb device 10C according to the present embodiment. The basic configuration of optical frequency comb device 10C is identical to that of optical frequency comb laser source 10 illustrated in FIGS. 2A and 2B. The following primarily describes differences from optical frequency comb laser source 10 illustrated in FIGS. 2A and 2B, and descriptions of common features will be omitted or simplified.

As illustrated in FIG. 8, optical frequency comb device 10C differs in further including modulator 21C. Modulator 21C is an example of the controller and includes fixed current source 17 and modulated RF signal generator 18m.

Fixed current source 17 is connected to gain media 13g to supply gain media 13g with the fixed current. The specific connection of fixed current source 17 is identical to that in Embodiment 2.

Modulated RF signal generator 18m is connected to saturable absorber 13sa to supply saturable absorber 13sa with a RF signal of which the frequency is modulated (hereinafter referred to as "modulated RF signal"). Specifically, modulated RF signal generator 18m is connected to p-doped layer 13d3 and n-doped layer 13d1 to supply, between p-doped layer 13d3 and n-doped layer 13d1, a radio frequency voltage signal of which the frequency is modulated as the modulated RF signal. This causes the modulated RF signal to be supplied to saturable absorber 13sa that is held between p-doped layer 13d3 and n-doped layer 13d1.

Fixed current source 17 fixes the carrier-envelope offset frequency by fixing the magnitude of the current supplied to gain media 13g. In contrast, modulated RF signal generator 18m modulates the repetition frequency by modulating the frequency of the RF signal.

This, as a result, achieves optical frequency comb device 10C that modulates only the repetition frequency, enabling FMCW-based distance measurement.

Note that, in each of the above-described embodiments, the magnitude of the current, the frequency of the RF signal, and the magnitude of the voltage are repeatedly modulated in a linear manner as in the case illustrated in FIG. 3. In the case where the carrier-envelope offset frequency is modulated, the frequency difference in the nth mode is $\delta f_{CEO}$, which does not depend on n. Thus, detecting a plurality of modes separately using, for example, wavelength division multiplexing enables FMCW-based distance measurement per mode. That is, the distances to and/or speeds of multiple points can be measured simultaneously. In the case where the plurality of modes are detected separately as above, overlaps between the modulation ranges of the modes do not need to be considered. This allows the modulation ranges to be increased. The detection using wavelength division multiplexing can be achieved using, for example, a demultiplexer that separates incident light into light beams per frequency and a plurality of light receptors that receive the light beams separated per frequency.

In contrast, in the case where the repetition frequency is modulated, the frequency difference in the nth mode is $n \times \delta f_{rep}$, which depends on n. Thus, the modes can be distinguished without receiving light beams separately for each mode. Note that, in this case, the modulation is performed such that the modulation ranges of the plurality of modes included in the optical frequency comb do not overlap each other.

Each of fixed current source 17, modulated current source 17m, fixed RF signal generator 18, modulated RF signal generator 18m, and modulated voltage source 19m is achieved by an electronic circuit that includes at least one of resistors, inductors, capacitors, transformers, diodes, or transistors. Such electronic circuits may be achieved by ICs (Integrated Circuits).

In the above-described embodiments, optical waveguide 13w, mirrors 13m1 and 13m2, gain media 13g, and saturable absorber 13sa are integrated on identical semiconductor substrate 14. That is, optical frequency comb devices 10A, 10B, and 10C are so-called on-chip optical frequency comb devices. This reduces the size of optical frequency comb devices 10A, 10B, and 10C.

In the above-described embodiments, modulators 21A, 21B, and 21C are components separate from semiconductor substrate 14. However, the configuration is not limited to this. For example, as illustrated in FIG. 9, modulator 21A may also be integrated on semiconductor substrate 14. FIG. 9 schematically illustrates optical frequency comb device 10D according to a variation of the embodiments. FIG. 9 illustrates a variation of optical frequency comb device 10A illustrated in FIG. 6. Similarly, modulator 21B in optical frequency comb device 10B illustrated in FIG. 7 or modulator 21C in optical frequency comb device 10C illustrated in FIG. 8 may be integrated on semiconductor substrate 14.

[Embodiment 4]

Subsequently, a measurement device including an optical frequency comb device will be described with reference to FIG. 10.

FIG. 10 schematically illustrates a configuration of measurement device 100 according to Embodiment 4. Measurement device 100 illustrated in FIG. 10 measures the distance to target 101 and/or the moving speed of target 101. Measurement device 100 includes optical frequency comb device 10A, couplers 111 and 112, circulator 113, emitter 120, detector 130, and signal processing circuit 140. Measurement device 100 may include optical frequency comb device 10B, 10C, or 10D instead of optical frequency comb device 10A.

Couplers 111 and 112 and circulator 113 are connected to optical fibers that guide optical frequency comb laser light 5 emitted from optical frequency comb device 10A. The optical fibers extend to connect outputter 15 of optical frequency comb device 10A to emitter 120, to connect circulator 113 to detector 130, and to connect coupler 111 to coupler 112.

Note that, as illustrated in FIG. 6, outputter 15 is disposed at an end of optical waveguide 13w. Specifically, outputter 15 is located on the outer side of mirror 13m2 to output optical frequency comb laser light 5 passing through mirror 13m2 to the outside. Outputter 15 includes, for example, a coupler connected to the optical fibers. Specifically, outputter 15 is, but not limited to, a grating coupler. Outputter 15 may output light through edge coupling.

Coupler 111 splits optical frequency comb laser light 5 into measurement light 5a and reference light 5b. Note that coupler 111 is an element that splits light at a predetermined intensity ratio and that the frequency, wavelength, and the like of the light do not change after the split. That is, both measurement light 5a and reference light 5b are the optical frequency combs that have the identical carrier-envelope offset frequency and the identical repetition frequency. The intensity ratio of measurement light 5a to reference light 5b is, for example, 9:1, but may be 1:1. Measurement light 5a is emitted from emitter 120 to target 101 through circulator 113. Reference light 5b enters detector 130 through coupler 112.

Emitter 120 is an optical element that emits measurement light 5a to target 101. Emitter 120 is a prism or a diffraction grating. Emitter 120 emits measurement light 5a in a different direction per frequency. In FIG. 10, a plurality of solid line arrows extending from emitter 120 to target 101 each indicate a light beam with a frequency component included in measurement light 5a. The light beams are reflected by different parts of target 101. Reflected light 5c generated by the reflection returns to emitter 120 and guided to coupler 112 by circulator 113. Note that circulator 113 is an optical element for limiting the traveling direction of light and prevents reflected light 5c guided from emitter 120 from returning to coupler 111.

Coupler 112 causes reference light 5b and reflected light 5c to be joined and to enter detector 130. The coupling ratio is, but not limited to, 1:1, for example.

Detector 130 is an example of a light detector and receives reference light 5b and reflected light 5c to generate and output an electrical signal based on the intensity of the incident light. In detector 130, interference between reference light 5b and reflected light 5c generates a beat signal. Detector 130 outputs an electrical signal that represents the time waveform of the beat signal. Note that detector 130 is, for example, a photoelectric transducer, such as a photodiode.

Signal processing circuit 140 is an example of an arithmetic unit and calculates the distance to target 101 and/or the speed of target 101, based on results of detection by detector 130. Specifically, signal processing circuit 140 calculates the distance and/or the speed, based on the beat signal. The method of calculating the distance used by signal processing circuit 140 has already been described with reference to FIG. 3. The speed can also be calculated based on a common FMCW method.

In the present embodiment, both reference light 5b and reflected light 5c are optical frequency combs. Accordingly, calculation per frequency yields the distance to and/or the moving speed of a part irradiated with light with the corresponding frequency. Thus, the distances to and/or the speeds of a plurality of parts of target 101 can be measured simultaneously. That is, measurement device 100 can perform FMCW-based simultaneous multipoint measurement.

As illustrated in FIG. 11, detector 130 may include demultiplexer 131 that separates incident light into light beams per frequency and a plurality of light receptors 132 that receive the light beams separated per frequency. The plurality of light receptors 132 correspond one-to-one with the plurality of separated frequencies. In this manner, receiving the signal per frequency separately enables accurate reception of light beams with individual frequency components, increasing the accuracy of distance measurement and speed measurement.

(Other embodiments)

Although optical frequency comb devices and measurement devices according to one or more aspects have been described above based on the foregoing embodiments, these embodiments are not intended to limit the present disclosure. The scope of the present disclosure encompasses forms obtained by various modifications, to the embodiments, that can be conceived by those skilled in the art and forms obtained by combining elements in different embodiments without departing from the spirit of the present disclosure.

For example, the modulator may not include the modulated current source or the fixed current source. That is, the gain media may perform stimulated emission by optical pumping instead of electrical excitation. For example, the modulator may include a laser light source instead of the modulated current source or the fixed current source. The laser light source irradiates the gain media with laser light as excitation light to excite the gain media. The laser light source can modulate carrier-envelope offset frequency $f_{CEO}$ by modulating the intensity of the laser light. Moreover, the laser light source can fix carrier-envelope offset frequency $f_{CEO}$ by fixing the intensity of the laser light.

Moreover, for example, the modulator may switch the frequency to be fixed and the frequency to be modulated between repetition frequency $f_{rep}$ and carrier-envelope offset frequency $f_{CEO}$. That is, the frequency to be fixed and the frequency to be modulated do not need to be the same at all times, and the modulators may switch the frequency to be fixed and the frequency to be modulated depending on the situation.

Specifically, the modulator may include two operating modes including a first mode in which repetition frequency $f_{rep}$ is fixed while carrier-envelope offset frequency $f_{CEO}$ is modulated and a second mode in which repetition frequency $f_{rep}$ is modulated while carrier-envelope offset frequency $f_{CEO}$ is fixed. The modulator may switch from the first mode to the second mode and from the second mode to the first mode.

Moreover, for example, the controller may not change the frequency by modulation. For example, the controller may change one of the repetition frequency and the carrier-envelope offset frequency between two predetermined values.

Moreover, various modifications, substitutions, additions, omissions, and the like can be made to the embodiments above within the scope of the claims or equivalents thereof.

[Industrial Applicability]

The present disclosure can be used as optical frequency comb devices and the like that can accurately change the frequencies, and can be used for devices and the like that perform, for example, detection and analysis of targets and measurement of distances to targets.

[Reference Signs List]

5 optical frequency comb laser light
5a measurement light
5b reference light
5c reflected light
10 optical frequency comb laser source
10A, 10B, 10C, 10D optical frequency comb devices
13 resonator
13d1 n-doped layer
13d2, 13d3 p-doped layers
13i Intermediate layer
13g gain media
13m1, 13m2 mirrors
13s semiconductor layer
13sa saturable absorber
13w optical waveguide
13w1 first portion
13w2 second portion
14 semiconductor substrate
14a high refractive index layer
14b low refractive index layer
15 outputter
16 protective layer
17 fixed current source
17m modulated current source
18 fixed RF signal generator
18m modulated RF signal generator
19m modulated voltage source
20 phase modulators

21A, 21B, 21C modulators
100 measurement device
101 target
111, 112 couplers
113 circulator
120 emitter
130 detector
131 demultiplexer
132 light receptors
140 signal processing circuit

**Claims**

1. An optical frequency comb device comprising:

   an optical waveguide;
   a first mirror disposed at a first position in the optical waveguide;
   a second mirror disposed at a second position different from the first position, in the optical waveguide;
   a gain medium and a saturable absorber which are disposed between the first mirror and the second mirror; and
   a controller that fixes one of a repetition frequency and a carrier-envelope offset frequency of an optical frequency comb output from an end of the optical waveguide, and changes the other of the repetition frequency and the carrier-envelope offset frequency.

2. The optical frequency comb device according to claim 1, wherein
   the controller includes:

   a current source that supplies current to the gain medium; and
   a signal generator that supplies a radio frequency signal to the saturable absorber.

3. The optical frequency comb device according to claim 2, wherein

   the current source changes the carrier-envelope offset frequency by changing a magnitude of the current, and
   the signal generator fixes a frequency of the radio frequency signal.

4. The optical frequency comb device according to claim 2, wherein

   the current source fixes a magnitude of the current, and
   the signal generator changes the repetition frequency by changing a frequency of the radio frequency signal.

5. The optical frequency comb device according to claim 2, further comprising:

   a phase modulator disposed between the first mirror and the second mirror, wherein
   the controller further includes a voltage source that supplies a voltage to the phase modulator,
   the voltage source changes the carrier-envelope offset frequency by changing a magnitude of the voltage, and
   the signal generator fixes a frequency of the radio frequency signal.

6. The optical frequency comb device according to any one of claims 1 to 5, further comprising:

   a semiconductor substrate, wherein
   the optical waveguide, the first mirror, the second mirror, the gain medium, and the saturable absorber are integrated on the semiconductor substrate.

7. The optical frequency comb device according to claim 6, wherein
   the controller is integrated on the semiconductor substrate.

8. An optical frequency comb device comprising:

an optical waveguide;

a first mirror disposed at a first position in the optical waveguide;

a second mirror disposed at a second position different from the first position, in the optical waveguide;

a gain medium and a saturable absorber which are disposed between the first mirror and the second mirror; and

a signal generator that supplies a radio frequency signal to the saturable absorber, wherein

the signal generator changes a repetition frequency of an optical frequency comb output from an end of the optical waveguide, by changing a frequency of the radio frequency signal.

9. The optical frequency comb device according to claim 8, further comprising:

a current source that supplies current to the gain medium, wherein

the current source fixes a magnitude of the current.

10. A measurement device, comprising:

the optical frequency comb device according to any one of claims 1 to 9;

an emitter that emits the optical frequency comb toward a target;

a light detector into which reflected light of the optical frequency comb that is reflected by the target enters; and

an arithmetic unit that calculates a distance to the target or a speed of the target, based on a result of detection by the light detector.

11. The measurement device according to claim 10, wherein

the optical frequency comb further enters the light detector, and

the arithmetic unit calculates the distance or the speed based on a beat signal generated by interference between the reflected light and the optical frequency comb in the light detector.

12. The measurement device according to claim 10 or 11, wherein
the light detector includes:

a demultiplexer that separates light entering the light detector into light beams per frequency; and

light receptors that receive the light beams separated per frequency.

13. The measurement device according to any one of claims 10 to 12, wherein
the emitter emits the optical frequency comb in a different direction per frequency.

# FIG. 1A

# FIG. 1B

EP 4 258 495 A1

# FIG. 2A

EP 4 258 495 A1

# FIG. 2C

EP 4 258 495 A1

# FIG. 3

FIG. 4

## FIG. 5

FIG. 6

EP 4 258 495 A1

FIG. 7

EP 4 258 495 A1

# FIG. 8

21C

17

Fixed current source

10C

14

13w1

13sa

13w2

15

13m1

13g

13g

13w

13m2

Modulated RF signal generator

18m

EP 4 258 495 A1

FIG. 9

EP 4 258 495 A1

FIG. 10

# FIG. 11

EP 4 258 495 A1

## INTERNATIONAL SEARCH REPORT

| International application No. |
| --- |
| **PCT/JP2021/041937** |

### A. CLASSIFICATION OF SUBJECT MATTER

*H01S 5/125*(2006.01)i; *G01S 17/34*(2020.01)i; *G02F 1/015*(2006.01)i; *G02F 1/025*(2006.01)i; *G02F 2/00*(2006.01)i
FI: H01S5/125; G02F2/00; G02F1/015 505; G02F1/025; G01S17/34

According to International Patent Classification (IPC) or to both national classification and IPC

### B. FIELDS SEARCHED

Minimum documentation searched (classification system followed by classification symbols)

H01S5/00-5/50, G01S7/48-7/51, 17/00-17/95, G02F1/00-1/125, 1/21-7/00

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2017-527121 A (OCLARO TECHNOLOGY LTD.) 14 September 2017 (2017-09-14)<br>entire text, all drawings | 1-13 |
| A | JP 2008-34657 A (OKI ELECTRIC IND. CO., LTD.) 14 February 2008 (2008-02-14)<br>entire text, all drawings | 1-13 |
| A | JP 2006-351571 A (OKI ELECTRIC IND. CO., LTD.) 28 December 2006 (2006-12-28)<br>entire text, all drawings | 1-13 |
| A | JP 2003-69138 A (OKI ELECTRIC IND. CO., LTD.) 07 March 2003 (2003-03-07)<br>entire text, all drawings | 1-13 |
| A | JP 2001-168845 A (OKI ELECTRIC IND. CO., LTD.) 22 June 2001 (2001-06-22)<br>entire text, all drawings | 1-13 |
| A | EP 3609028 A1 (TECHNISCHE UNIVERSITAET WIEN) 12 February 2020 (2020-02-12)<br>entire text, all drawings | 1-13 |

☑ Further documents are listed in the continuation of Box C.  ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **14 December 2021** | **28 December 2021** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

28

**INTERNATIONAL SEARCH REPORT**

International application No.

**PCT/JP2021/041937**

C. DOCUMENTS CONSIDERED TO BE RELEVANT

| Category* | Citation of document, with indication, where appropriate, of the relevant passages | Relevant to claim No. |
|---|---|---|
| A | US 2019/0058304 A1 (NOKIA SOLUTIONS AND NETWORKS OY) 21 February 2019 (2019-02-21)<br>entire text, all drawings | 1-13 |
| A | US 2007/0071060 A1 (MENLO SYSTEMS GMBH) 29 March 2007 (2007-03-29)<br>entire text, all drawings | 1-13 |
| A | US 2014/0185635 A1 (COX, Jonathan A.) 03 July 2014 (2014-07-03)<br>entire text, all drawings | 1-13 |

Form PCT/ISA/210 (second sheet) (January 2015)

**INTERNATIONAL SEARCH REPORT**
Information on patent family members

International application No.

**PCT/JP2021/041937**

| Patent document cited in search report | | | Publication date (day/month/year) | Patent family member(s) | | | Publication date (day/month/year) |
|---|---|---|---|---|---|---|---|
| JP | 2017-527121 | A | 14 September 2017 | US | 2014/0301416 | A1 | |
| | | | | GB | 2493988 | A | |
| | | | | WO | 2013/030550 | A2 | |
| | | | | CN | 103858294 | A | |
| JP | 2008-34657 | A | 14 February 2008 | US | 2008/0025358 | A1 | |
| | | | | CN | 101114755 | A | |
| JP | 2006-351571 | A | 28 December 2006 | (Family: none) | | | |
| JP | 2003-69138 | A | 07 March 2003 | (Family: none) | | | |
| JP | 2001-168845 | A | 22 June 2001 | (Family: none) | | | |
| EP | 3609028 | A1 | 12 February 2020 | WO | 2020/030772 | A1 | |
| US | 2019/0058304 | A1 | 21 February 2019 | WO | 2019/036584 | A1 | |
| US | 2007/0071060 | A1 | 29 March 2007 | DE | 102005035173 | A1 | |
| US | 2014/0185635 | A1 | 03 July 2014 | WO | 2013/040168 | A2 | |

Form PCT/ISA/210 (patent family annex) (January 2015)

30

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. L. GAETA et al.** Photonic-chip-based frequency combs. *Nature Photonics,* 2019, vol. 13, 158-169
- **J. RIEMENSBERGER et al.** Massively parallel coherent laser ranging using a soliton microcomb. *Nature,* 2020, vol. 581, 161-170

- **Z. WANG et al.** A III-V-on-Si ultra-dense comb laser. *Light: Science & Applications,* 2017, vol. 6, e16260